# EUROPEAN PATENT SPECIFICATION

(11) **EP 3 635 827 B1**
(45) Date of publication and mention of the grant of the patent: **17.01.2024**
(21) Application number: 18799265.6
(22) Date of filing: 30.04.2018
(51) Int. Cl.: H01S 5/22, H01S 5/065, H01S 5/12, H01S 5/34, H01S 5/10

(54) **DISTRIBUTED FEEDBACK INTERBAND CASCADE LASERS WITH CORRUGATED SIDEWALL**
INTERBANDKASKADENLASER MIT VERTEILTER RÜCKKOPPLUNG UND GEWELLTER SEITENWAND
LASERS EN CASCADE INTERBANDE À RÉTROACTION DISTRIBUÉE PRÉSENTANT UNE PAROI LATÉRALE ONDULÉE

(30) Priority: 08.05.2017 US 201762503063 P; 15.05.2017 US 201762506338 P
(43) Date of publication of application: 15.04.2020
(73) Proprietor: Thorlabs Quantum Electronics, Inc., Jessup, MD 20794 (US)
(72) Inventor: XIE, Feng, Jessup, MD 20794 (US); PHAM, John, Jessup, MD 20794 (US); STOCKER, Michael, P., Jessup, MD 20794 (US); LASCOLA, Kevin, Jessup, MD 20794 (US)
(74) Representative: Grättinger Möhring von Poschinger Patentanwälte Partnerschaft mbB
(86) International application number: PCT/US2018/030249
(87) International publication number: WO 2018/208531

(56) References cited:
- WO-A1-2017/039767
- US-A1- 2007 248 134
- US-A1- 2007 263 694
- US-A1- 2010 296 539
- US-A1- 2016 156 153
- VURGAFTMAN I ET AL: "Interband cascade lasers", JOURNAL OF PHYSICS D: APPLIED PHYSICS, INSTITUTE OF PHYSICS PUBLISHING LTD, GB, vol. 48, no. 12, 11 March 2015 (2015-03-11), page 123001, XP020282031, ISSN: 0022-3727, DOI: 10.1088/0022-3727/48/12/123001 [retrieved on 2015-03-11]
- WILLIAM W. BEWLEY ET AL: "High-power room-temperature continuous-wave mid-infrared interband cascade lasers", OPTICS EXPRESS, vol. 20, no. 19, 10 September 2012 (2012-09-10), page 20894, XP055763782, US ISSN: 2161-2072, DOI: 10.1364/OE.20.020894
- BAUER A ET AL: "Mid-infrared semiconductor heterostructure lasers for gas sensing applications;Mid-infrared semiconductor heterostructure lasers for gas sensing applications", SEMICONDUCTOR SCIENCE AND TECHNOLOGY, IOP PUBLISHING LTD, GB, vol. 26, no. 1, 15 December 2010 (2010-12-15), page 14032, XP020202468, ISSN: 0268-1242, DOI: 10.1088/0268-1242/26/1/014032
- KIM C S ET AL: "Mid-infrared distributed-feedback interband cascade lasers with continuous-wave single-mode emission to 80", APPLIED PHYSICS LETTERS, A I P PUBLISHING LLC, US, vol. 101, no. 6, 6 August 2012 (2012-08-06), pages 61104-61104, XP012164261, ISSN: 0003-6951, DOI: 10.1063/1.4744445 [retrieved on 2012-08-06]
- KALCHMAR S. et al.: "High tuning stability of sampled grating quantum cascade lasers", Optics Express, vol. 23, no. 12, 2015, pages 15734-15747, XP055547135,
- FENG XIE. et al.: "Distributed feedback interband cascade lasers with top grating and corrugated Sidewalls", APPLIED PHYSICS LETTERS, vol. 112, no. 13, 27 March 2018 (2018-03-27), pages 131102-1-131102-5, XP012227309,

## Description

### CROSS REFERENCE TO RELATED APPLICATIONS

This application claims the benefit of U.S. Provisional Patent Application No. 62/503,063 filed on May 8, 2017, and U.S. Provisional Patent Application No. 62/506,338 filed on May 15, 2017.

### STATEMENT REGARDING FEDERALLY SPONSORED RESEARCH OR DEVELOPMENT

This invention was made with government support under ARPA-E subcontract through Physical Sciences Inc. (PSI): Agreement No. SC67247-1867 awarded by the U.S. Department of Energy. The government has certain rights in the invention.

### FIELD OF THE INVENTION

The invention generally relates to laser devices. More particularly, the invention relates to distributed feedback interband cascade lasers with corrugated sidewalls.

### BACKGROUND

This document discloses a distributed feedback (DFB) interband cascade laser (ICL) that can lase at a single wavelength, which is crucial for gas sensing applications, especially for methane detection. Therefore, it is important that one can repeatedly make DFB ICLs that lase at a single wavelength.

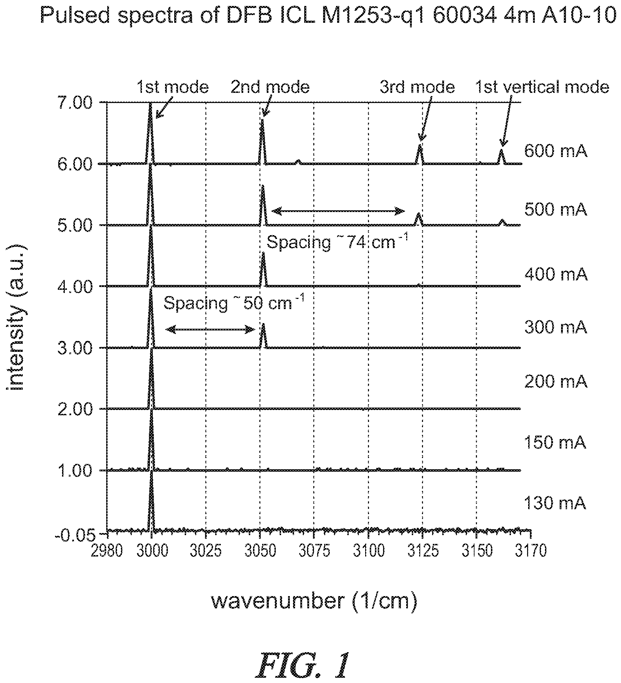

DFB lasers operate by introducing a wavelength-selective grating into the device structure in order to achieve single-wavelength operation. A wide variety of DFB structures have been developed to improve the performance and manufacturing yield of conventional buried-heterostructure (BH) DFBs, such as a quarter-wavelength shift in the grating (Ref. 1), corrugation-pitch-modulated phase arranging region (Ref. 2), or a partially corrugated grating section at the output facet (Ref. 3). A typical ICL is made with a ridge waveguide structure, instead of a BH structure, due to the lack of regrowth capability for the ICL material system with existing epitaxial growth technologies. A ridge waveguide is created by etching parallel trenches in the laser material to create an isolated stripe of gain material. A dielectric material is typically deposited in the trenches to guide injected current into the ridge, then the entire ridge is typically coated with gold to provide electrical contact. A BH waveguide is a waveguide structure, in which laser gain material is etched to produce an isolated ridge, but a new semiconductor material is grown over the ridge. The change in index of refraction between the laser gain material and the overgrown material is sufficient to create a waveguide, as shown in Ref. 7. In a BH structure, the grating can be located close to the active region so that there is strong overlap of the optical field between the active region and grating which facilitates single-wavelength operation. In a ridge structure, the grating is located farther from the active region so the interaction is weaker than in a BH structure. A straightforward way to make a DFB ICL is to etch a grating on top of the wafer before performing the ridge etching and depositing a metal contact on top surface. However, due to the difficulty of etching a deep and narrow mesa, it is very hard to suppress the optical higher order lateral modes in an ICL. The typical narrowest ridge width that can be made with good yield is about 4 µm. With this stripe width, the waveguide structure can easily support up to the second higher order mode, with a typical ICL wavelength (around 3 µm). For a 5 µm wide stripe, the structure can even support a first vertical higher order mode. Fig. 1 illustrates the measured lasing spectrum of a regular DFB ICL at different currents. It can be seen the DFB ICL lases at multiple discrete wavelengths, especially at higher operating current, instead of lasing at single wavelength (the fundamental mode). At 500 mA, the lasing wavelengths include the first, second and third lateral higher order modes and the first vertical higher order mode. The wavelengths match the prediction based on the grating pitch and the effective index calculation in waveguide simulations. The reason behind this is that the ridge stripe is so wide compared to the wavelength that the high order modes have waveguide losses and confinement factors comparable to that of the fundamental mode. Therefore, the DFB ICL will lase at all allowable modes, including both the fundamental mode and higher order modes.

To solve this problem, one needs to either increase the waveguide losses of higher order modes, or reduce the confinement factors of higher order modes, because the gain needed for lasing at specific mode is g=(α_{w}+ αₘ)/Γ, where α_{w} is the waveguide loss, αₘ is the mirror loss, and Γ is the confinement factor. For a DFB ICL, it is difficult to make the ridge narrow enough to increase the waveguide loss for higher order modes, and it is also not currently feasible to make BH structures to reduce the confinement factor for high order modes. On the other hand, comparing to near infrared DFB diode lasers, the DFB ICLs have a high voltage drop. This results in huge current spreading if one tries to avoid etching the core area, which is the solution of this problem for a DFB diode laser by making the optical mode less confined in a waveguide.

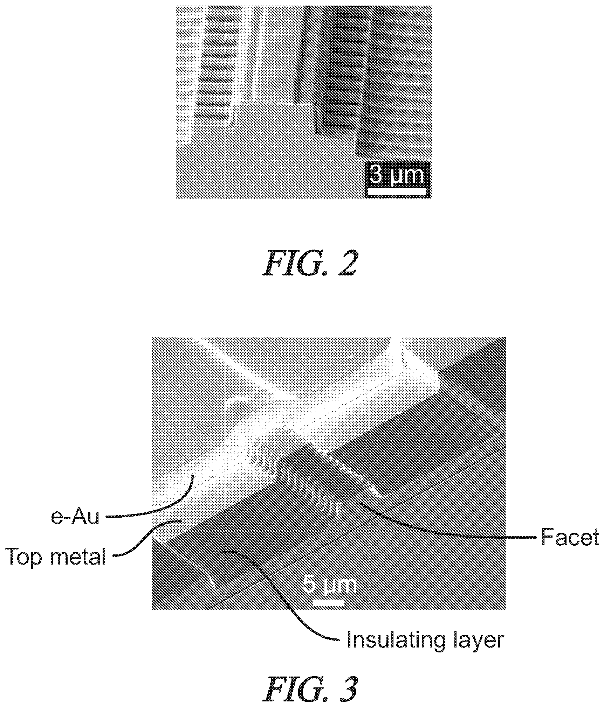

One solution for a DFB ICL that was introduced by Borgentun et al. (Refs. 5 and 6) is to make the waveguide structure into a step-shape, as shown in the Fig. 2. The grating is placed closer to the core, namely closer to the optical mode, than in the regular ridge structure. The second ridge (top ridge) is used to introduce weak index difference between center and side of the first ridge (bottom ridge), so that the fundamental mode is preferred. However, a simulation shows that this structure introduces neither a large difference in optical losses, nor a large difference in confinement factors between the fundamental mode and high order modes. Quite the opposite, it is believed that this structure gives higher grating feedback to the first higher order mode than the fundamental mode. Therefore it may favor the first higher order mode than the fundamental mode. Therefore, this solution is not a good approach.

Another solution that is used by Naval Research Lab is to make a grating on the sidewall, as shown in Fig. 3. The sidewall grating also has the function of a corrugated side wall, which introduces extra high loss for higher order modes (Ref. 7). However, it is challenging to make fine grating structures on the sidewall and etch it deep through laser core. To mitigate this problem, people tend to use a high order grating pitch (fourth order grating pitch in Ref. 7), which typically results in a low yield on the single mode operation as the device tends to lase on both DFB modes. Moreover, because the semiconductor material composition varies significantly in the growth direction, and different materials respond differently to same etching chemical solution, when they are all exposed on the sidewall in the grating etching, it makes the etching process very unreliable. Therefore, this approach may not be a good solution for volume production.

Therefore, there is a long-felt need for a method to make DFB ICLs that can lase at a single wavelength without the above mentioned problems.

US 2007/263694 A1 and US 2010/296539 A1 each discloses a semiconductor laser having first and second sampled Bragg diffractive grating regions with respective first and second discrete peaks of a reflection spectrum of different wavelength intervals. In US 2007/263694 A1, the first or second diffractive grating has a convex width portion or a concave width portion, the optical length of the convex portion or the concave portion being an odd multiple of half of the pitch of the diffractive grating.

US 2007/248134 A1 discloses a semiconductor laser with a buried ridge waveguide having a vertical DFB grating formed in sidewalls thereof, and having wide, narrow and intermediate width portions along a propagation direction, wherein the narrow width portion is formed such that a loss of 50% or more is given to a higher order transverse mode.

VURGAFTMAN IET AL: "Interband cascade lasers",JOURNAL OF PHYSICS D: APPLIED PHYSICS, INSTITUTE OF PHYSICS PUBLISHING LTD, GB, vol. 48, no. 12, 11 March 2015 (2015-03-11), page 123001, XP020282031, discusses various mid-infrared DFB interband cascade lasers, including structures with variable ridge width, corrugated sidewalls, and tapered ridges.

### SUMMARY

One embodiment of the present invention provides an interband cascade laser as defined in claim 1, including: a ridge waveguide having alternating first and second regions; wherein the first region has a constant width, and the second region has a width that matches that of the first region at boundaries between the first region and the second region, and the width of the second region increases to a maximum that is larger than the width of the first region, such that a partially-corrugated sidewall along each side of the ridge waveguide is formed; wherein the first region comprises a grating structure, and due to periodic nature of the first region, the grating structure is in a form of a sampled grating; and wherein the partially-corrugated sidewall increases waveguide losses for radiation in higher order lateral modes as compared to the fundamental waveguide mode.

Another embodiment of the present invention provides a semiconductor laser as defined in claim 7, including: a ridge or buried waveguide having alternating first and second regions; wherein the first region has a constant width, and the second region has a width that matches that of the first region at boundaries between the first region and the second region, and the width of the second region increases to a maximum that is larger than the width of the first region, such that a partially-corrugated sidewall or interface on each side of the waveguide is formed; wherein the first region comprises a grating structure, and due to periodic nature of the first region, the grating structure is in a form of a sampled grating; and wherein the partially-corrugated sidewall or interface increases waveguide losses for radiation in high order lateral modes as compared to the fundamental waveguide mode.

Another embodiment of the present invention provides an interband cascade laser as defined in claim 13, comprising: a ridge waveguide having alternating first and second regions; wherein the first region has a constant width, and the second region has a width that matches that of the first region at boundaries between the first region and the second region, and the width of the second region decreases to a minimum that is smaller than the width of the first region, such that a partially-corrugated sidewall along each side of the ridge waveguide is formed; wherein the first region comprises a grating structure, and due to periodic nature of the first region, the grating structure is in a form of a sampled grating; and wherein the partially-corrugated sidewall increases waveguide losses for radiation in higher order lateral modes as compared to the fundamental waveguide mode.

Another embodiment of the present invention provides a semiconductor laser as defined in claim 14, comprising: a ridge or buried waveguide having alternating first and second regions; wherein the first region has a constant width, and the second region has a width that matches that of the first region at boundaries between the first region and the second region, and the width of the second region decreases to a minimum that is smaller than the width of the first region, such that a partially-corrugated sidewall along each side of the ridge waveguide is formed; wherein the first region comprises a grating structure, and due to periodic nature of the first region, the grating structure is in a form of a sampled grating; and wherein the partially-corrugated sidewall increases waveguide losses for radiation in higher order lateral modes as compared to the fundamental waveguide mode.

The device according to the invention can lase at a single wavelength. Key features of the invention are to use a corrugated sidewall to suppress high order lateral optical mode in lasers, and to use a sampled grating structure to avoid any potential impact of the corrugated sidewall to the DFB linewidth.

Note that the corrugated sidewall feature according to an embodiment of the present invention is different from other uses of corrugated structures (e.g., Refs. 1 - 3). Ref. 1 describes a quarter-wavelength shifted corrugation in the laser section. Ref. 2 describes a corrugation-pitch modulated structure. Ref. 3 describes a grating of limited spatial extent, similar to that in a Distributed Bragg Reflector (DBR) laser. However, Refs. 1-3 describe partial corrugation in a grating, rather than a waveguide. In contrast, the present invention teaches partially corrugating the sidewall of the waveguide.

### BRIEF DESCRIPTION OF THE DRAWINGS

Fig. 1 shows the lasing spectra of a regular DFB ICL at different currents.
Fig. 2 shows an existing waveguide structure.
Fig. 3 is an existing corrugated sidewall grating structure for DFB ICL.
Fig. 4A is a schematic drawing of waveguide structure that combines sampled grating and partially-corrugated sidewall in accordance with an embodiment.
Fig. 4B is a schematic drawing of waveguide structure that combines sampled grating and partially-corrugated sidewall in accordance with another embodiment.
Fig. 4C is a schematic drawing of waveguide structure that combines sampled grating and partially-corrugated sidewall in accordance with another embodiment.
Fig. 4D is a schematic drawing of waveguide structure that combines sampled grating and partially-corrugated sidewall in accordance with another embodiment.
Fig. 5 shows the waveguide loss of various modes in the partially-corrugated sidewall structure with varied depth of sidewall in accordance with an embodiment.
Fig. 6 shows the waveguide loss increment of the 1st order mode at various stripe widths and various period of corrugated sidewall in accordance with an embodiment.
Fig. 7 shows a SEM picture of a sample wafer showing a ridge structure with partially-corrugated sidewall and sampled top grating as designed in accordance with an embodiment.
Fig. 8A shows the CW LIV of a DFB ICL with partially-corrugated sidewall at 25 °C and 35 °C.
Fig. 8B shows the CW spectra of the laser at 25 °C and 35 °C.
Fig. 9 shows the CW lasing spectra of a DFB ICL with a straight ridge waveguide in accordance with an embodiment.

### DETAILED DESCRIPTION OF THE PREFERRED EMBODIMENTS

The description of illustrative embodiments according to principles of the present invention is intended to be read in connection with the accompanying drawings, which are to be considered part of the entire written description. In the description of embodiments of the invention disclosed herein, any reference to direction or orientation is merely intended for convenience of description and is not intended in any way to limit the scope of the present invention. Relative terms such as "lower," "upper," "horizontal," "vertical," "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description only and do not require that the apparatus be constructed or operated in a particular orientation unless explicitly indicated as such. Terms such as "attached," "affixed," "connected," "coupled," "interconnected," and similar refer to a relationship wherein structures are secured or attached to one another either directly or indirectly through intervening structures, as well as both movable or rigid attachments or relationships, unless expressly described otherwise. Moreover, the features and benefits of the invention are illustrated by reference to the exemplified embodiments. Accordingly, the invention expressly should not be limited to such exemplary embodiments illustrating some possible non-limiting combination of features that may exist alone or in other combinations of features; the scope of the invention being defined by the claims appended hereto.

This disclosure describes the best mode or modes of practicing the invention as presently contemplated. This description is not intended to be understood in a limiting sense, but provides an example of the invention presented solely for illustrative purposes by reference to the accompanying drawings to advise one of ordinary skill in the art of the advantages and construction of the invention. In the various views of the drawings, like reference characters designate like or similar parts.

In order to make DFB ICLs that can lase at a single wavelength without the above mentioned problems, an embodiment of the present invention is to introduce extra high losses for higher order modes by implementing a corrugated sidewall on the ridge structure.

It is known that a coarse corrugated sidewall can suppress high order modes in ICL. As shown in Ref. 8, an ICL that has an 18 µm wide stripe with corrugated sidewalls can still produce good Gaussian shape far field pattern, which indicates that the device lased on fundamental lateral mode.

However just combining a coarse corrugated sidewall with top grating may cause another problem. The corrugated sidewall can be viewed as a variation in stripe width along the beam propagation direction. The variation of stripe width changes the effective modal index. This potentially would change the linewidth of the DFB emission.

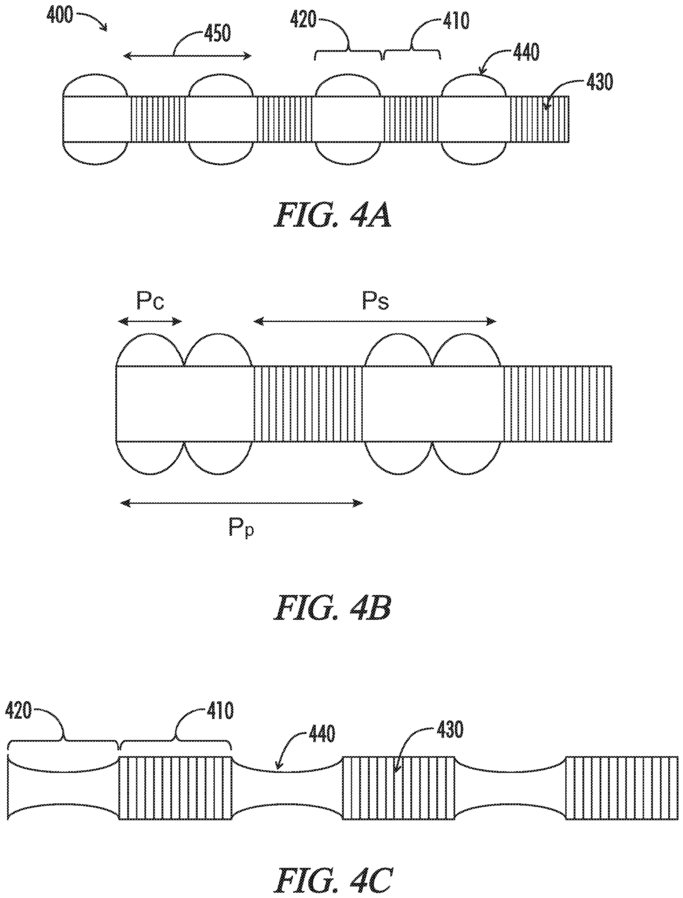

To solve this problem, an embodiment of the present invention provides a structure that combines a sampled grating with a partially-corrugated sidewall section, as shown in Fig. 4A. Along the waveguide structure 400, the groups of gratings 430 and corrugated sidewall sections 440 are arranged in an alternating pattern, so that the part of waveguide ridge 410 where the grating is located is straight, and the part of the waveguide ridge 420 with the corrugated sidewall has no grating. In this partially corrugated sidewall (PCS) structure, the grating structure is not impacted by the variation of stripe width of corrugated side wall as it is only present in the straight portion of the waveguide.

In accordance with the invention a sampled grating is used instead of a continuous grating for this structure. A sampled grating in a laser results in several evenly spaced peaks in the reflectivity spectrum. The spacing is determined by the formula: Δν=1/(2n_{g}Λₛ), where Δv is the spacing between reflectivity peaks in the unit of wavenumber, n_{g} is the effective index (group index), and Λₛ is the sampling period. Physically, the sampling period corresponds to the distance from the start of one grating section to the start of the adjacent grating section. If the gain profile is wide enough in frequency domain, the laser with a sampled grating would lase at all the wavelengths at the reflectivity peaks. However, lasing at all these wavelengths is not desired for a DFB laser. It is desired that the laser lases only at the zeroth order of the reflectivity peaks, which has the highest reflectivity among the peaks, and corresponds to the Bragg wavelength of the grating. Therefore, the spacing needs to be larger than the gain width or the full width at half maximum of the gain profile of an ICL, which is typically about 100~150 cm⁻¹, so that the laser will not lase at ± first or any other higher order reflectivity peaks. For example, a sampling period less than 10 µm yields a spacing of reflectivity peaks larger than 136 cm⁻¹. In order to maximize the excess loss for the higher order lateral modes, the period 450 of the PCS should be equal to the sampling period, as shown in Fig. 4A.

This means that the period of the PCS should also be less than 10 µm. The length of the PCS section is determined such that there is no difficulty in etching the corrugated features during wafer fabrication. In this embodiment, a sampling period of 8 µm, a grating section length of 4 µm, a PCS section length of 4 µm, and a PCS section length equal to half of the sampling period were selected. In Fig. 4B, the Pₛ is the period of sampling period of grating. The Pₚ is the period of PCS, and the P_{c} is the period of corrugation. In one embodiment, as shown in Fig. 4B, each of the no grating part of the waveguide ridge 420 includes multiple periods of corrugation.

Another embodiment of the present invention provides a structure that combines a sampled grating with a partially-corrugated sidewall section, as shown in Fig. 4C. Along the waveguide structure 400, the groups of gratings 430 and corrugated sidewall sections 440 are arranged in an alternating pattern, so that the part of waveguide ridge 410 where the grating is located is straight, and the part of the waveguide ridge 420 with the corrugated sidewall has no grating. Unlike Fig. 4A, the corrugated sidewall sections 440 have a narrower waist than the width of the grating sections 410.

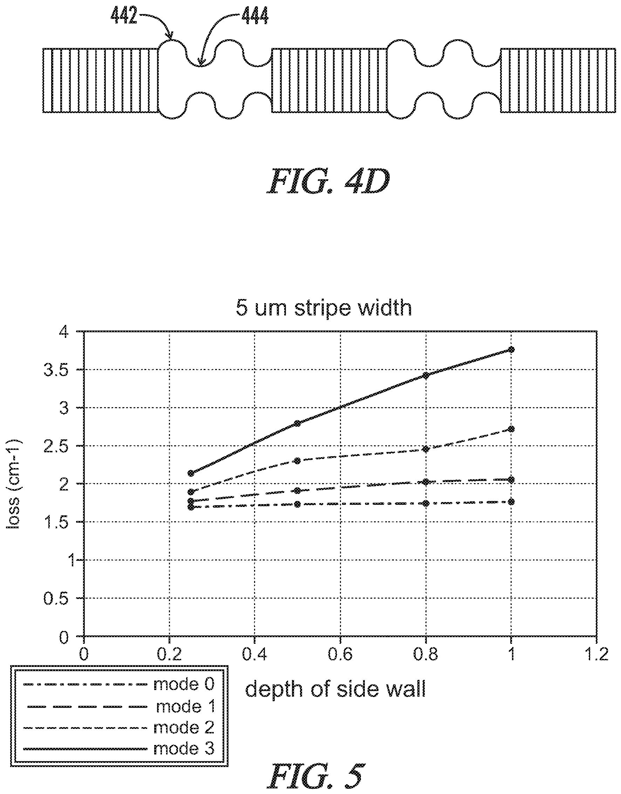

Another embodiment of the present invention provides a structure that combines a sampled grating with a partially-corrugated sidewall section, as shown in Fig. 4D. In this embodiment, the corrugated side wall sections have a maximum width 442 and a minimum width 444. The maximum width 442 is larger than the width of the grating sections and the minimum width 444 is smaller than the width of the grating sections. Furthermore, in one embodiment, each of the corrugated sidewall sections includes multiple maxima and minima.

Waveguide simulation has been performed for waveguide structures with various corrugation periods, and the additional waveguide losses introduced by the corrugated sidewall to the fundamental, first, second, and third order high order modes have been calculated.

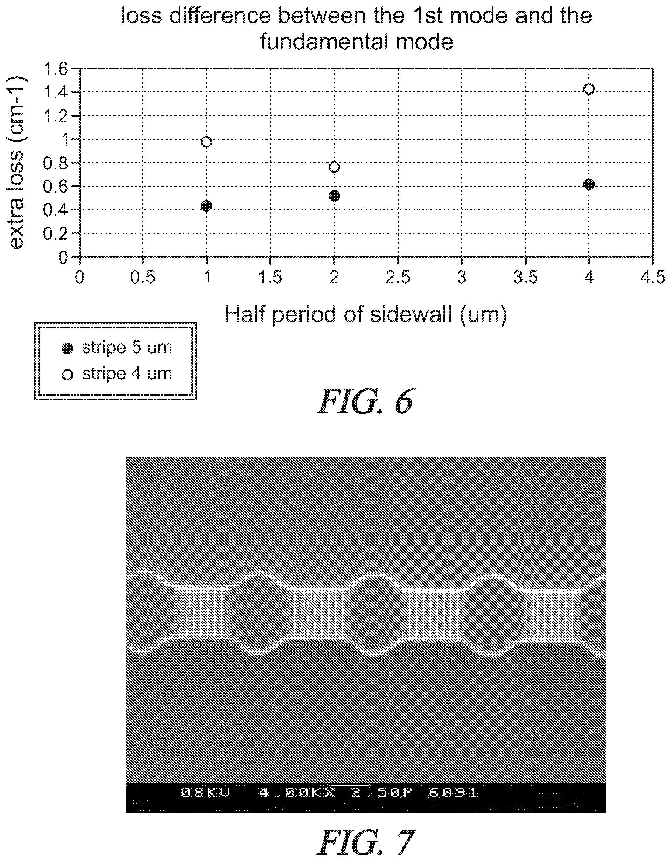

As shown in Fig. 5, the waveguide losses of the high order modes increases with the depth of the corrugated side wall. For the higher order modes, the loss increases faster. For the fundamental mode, the waveguide loss barely increases. This indicates that the corrugated sidewall in principle increases the waveguide losses for high order modes. The first order mode has the smallest loss increment in the high order mode. Therefore if the loss is increased enough to suppress the first order mode, other high order modes are also suppressed. To understand how to increase the loss enough for the first order mode, the impact of the period of the corrugated sidewall on the loss increments on the first order mode has been studied. In Fig. 6, it can be seen that the loss increases with the period of corrugation of 1 µm, 2 µm, and 4 µm, for two cases: stripe width at 4 µm and 5 µm. As shown in Fig. 6, when the period of corrugation is 4 µm, and the stripe width is 4 µm, the loss increase of the first order mode is 1.4 cm⁻¹, which is about 70% of the original loss of the first order mode in the simulation. This is considered to be a significant increase.

Based on this simulation study, new masks for a DFB ICL with the PCS were been designed, and the wafer has been fabricated. Fig. 7 is a scanning electron microscope (SEM) picture of a sample wafer showing the sampled grating and corrugated sidewall that are made as designed.

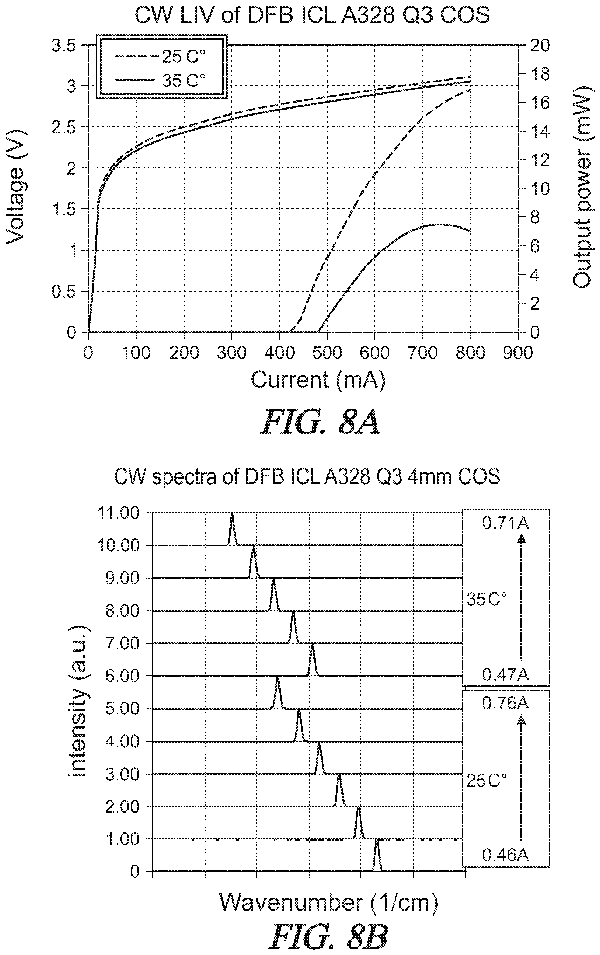

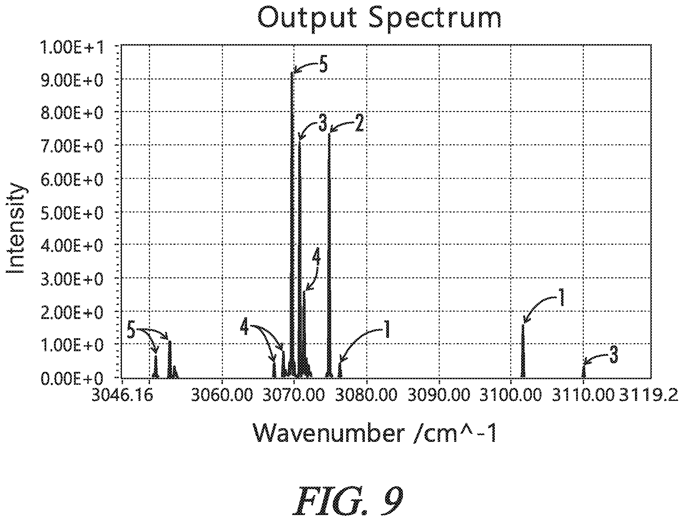

Fig. 8 shows the continuous-wave (CW) light-current-voltage (LIV) characteristic curves and spectra at various currents of one DFB ICL with corrugated sidewall obtained. As shown in Fig. 8, the DFB ICL lases at a single fundamental wavelength for varied temperature and over the whole current range in operation. For comparison, a few regular DFB ICLs (without corrugated sidewall) on the same wafer have been made. As shown in Fig. 9, a regular DFB ICL without corrugated sidewall lased at multiple wavelengths, including a few high order modes(for each of the spectra 1 - 5). Therefore, an embodiment of the present invention has a unique advantage over other devices.

In summary, an embodiment of the present invention provides a structure that combines a sampled grating and corrugated sidewalls for DFB ICLs. In this embodiment, high order modes are successfully suppressed. Single fundamental lasing with DFB ICLs as designed has been achieved. To further improve a single mode yield, a wavelength-shift design can be implemented in the grating structure, as illustrated in Ref. 9.

Note that in order to better illustrate embodiments of the present invention, distributed feedback interband cascade lasers are used as non-limiting examples in this document. It is contemplated that the waveguide structure in some embodiments of the present invention are applicable to other distributed feedback semiconductor lasers.

### References

| | |
|---|---|
| Ref. 1 | Nobuo Kobayashi et al. Nobuo Kobayashi, Akihito Noda, Tohru Watanabe, Shuichi Miura, Tetsufumi Odagawa, and Shouichi Ogita "2.5-Gb/s-1200-km Transmission of Electroabsorption Modulator-Integrated DFB Laser with Quarter-Wavelength-Shifted Corrugation," IEEE Photonics Technology Letters, Vol. 11, No. 8, August 1999. |
| Ref. 2 | Makoto Okai, Tomonobu Tsuchiya, Kazuhisa Uomi, Naoki Chinone, and Tatsuo Harada "Corrugation-Pitch Modulated MQW-DFB Lasers with Narrow Spectral Linewidth," IEEE Journal of Quantum Electronics, Vol. 27, No. 6. June 1991. |
| Ref. 3 | Pierre Doussiere, Mark Tashima, Hery Djie, Kong Weng Lee, Vince Wong, David Venables, Victor Rossin, and Erik Zucker "830nm High Power Single Mode DFB Laser for High Volume Applications," Novel In-Plane Semiconductor Lasers XI, edited by Alexey A. Belyanin, Peter M. Smowton, Proc. of SPIE Vol. 8277, 82770A, 2012. |
| Ref. 4 | US Patent 4,425,650 A |
| Ref. 5 | Carl Borgentun, Clifford Frez, Ryan M. Briggs, Mathieu Fradet, and Siamak Forouhar "Single-mode high-power interband cascade lasers for mid-infrared absorption spectroscopy," Optics Express, 23, 2446 (2015). |
| Ref. 6 | US Patent 9,438,011 B2. |
| Ref. 7 | C. S. Kim, M. Kim, W. W. Bewley, J. R. Lindle, C. L. Canedy, J. Abell, I. Vurgaftman, and J. R. Meyer, "Corrugated-sidewall interband cascade lasers with single-mode midwave-infrared emission at room temperature," Applied Physics Letter, 95, 231103 (2009). |
| Ref. 8 | William W. Bewley, Chadwick L. Canedy, Chul Soo Kim, Mijin Kim, Charles D. Merritt, Joshua Abell, Igor Vurgaftman, and Jerry R. Meyer, "High-power room-temperature continuous-wave mid-infrared interband cascade lasers", Optics Express, 20, 20894 (2012). |
| Ref. 9 | K. Ultaka, S. Akiba, and K. Sakai, "Analysis of quarter-wave-shifted DFB lasers," Electronics Letters, vol. 20, no. 8, pp. 326-327, April 12, 1984. |

While the present invention has been described at some length and with some particularity with respect to the several described embodiments, it is not intended that it should be limited to any such particulars or embodiments or any particular embodiment, but it is to be construed as being defined by the appended claims so as to provide the broadest possible interpretation of such claims and, therefore, to effectively encompass the intended scope of the invention.

## Claims

1. An interband cascade distributed feedback, DFB, laser comprising:
a ridge waveguide (400) having alternating first and second regions (410, 420);
wherein the first region (410) has a constant width, and the second region (420) has a width (440) that matches that of the first region (410) at boundaries between the first region (410) and the second region (420), and the width (440) of the second region (420) increases at least once to a maximum that is larger than the width of the first region (410), such that a partially-corrugated sidewall along each side of the ridge waveguide is formed;
wherein the first region (410) comprises a wavelength-selective Bragg grating structure configured for a selected wavelength (430), and due to periodic nature of the first region (410), the wavelength-selective Bragg grating structure (430) is in a form of a sampled grating;
wherein the second region does not have the wavelength-selective Bragg grating structure; and
wherein the partially-corrugated sidewall increases waveguide losses for radiation in higher order lateral modes as compared to the fundamental waveguide mode.

2. The laser of claim 1, wherein a sampling period of the grating structure is less than 10 µm.

3. The laser of claim 1, wherein each second region section length is equal to half of a sampling period of the grating structure.

4. The laser of claim 1, wherein the waveguide width of the first region is 4 µm to 5 µm, and the corrugation period within the partially-corrugated sidewall section is 2 µm to 5 µm.

5. The laser of claim 1, wherein the grating comprises a phase shift along the waveguide, so that the laser is a phase-shifted distributed feedback, DFB, laser.

6. The laser of claim 5, wherein the laser is a quarter-wavelength-phase-shifted DFB laser.

7. A semiconductor distributed feedback, DFB, laser comprising:
a ridge or buried waveguide (400) having alternating first and second regions (410, 420);
wherein the first region (410) has a constant width, and the second region (420) has a width (440) that matches that of the first region (410) at boundaries between the first region (410) and the second region (420), and the width (440) of the second region (420) increases at least once to a maximum that is larger than the width of the first region (410), such that a partially-corrugated sidewall or interface on each side of the waveguide is formed;
wherein the first region (410) comprises a wavelength-selective Bragg grating structure configured for a selected wavelength (430), and due to periodic nature of the first region (410), the wavelength-selective Bragg grating structure (430) is in a form of a sampled grating;
wherein the second region does not have the wavelength-selective Bragg grating structure; and
wherein the partially-corrugated sidewall or interface increases waveguide losses for radiation in high order lateral modes as compared to the fundamental waveguide mode.

8. The laser of claim 1 or 7, wherein a sampling period of the grating structure is selected such that spacing of resulting evenly spaced peaks in a reflectivity spectrum is greater than the full width at half maximum of a gain profile of the laser.

9. The laser of claim 1 or 7, wherein a grating pitch of the grating structure is selected such that radiation in the zero order of reflectivity peak is preferred.

10. The laser of claim 7, wherein each second region section length is equal to half of a sampling period of the grating structure.

11. The laser of claim 7, wherein the grating comprises a phase shift along the waveguide, so that the laser is a phase-shifted distributed feedback, DFB, laser.

12. The laser of claim 11, wherein the laser is a quarter-wavelength-phase-shifted DFB laser.

13. An interband cascade distributed feedback, DFB, laser comprising:
a ridge waveguide having alternating first and second regions (410, 420);
wherein the first region (410) has a constant width, and the second region (420) has a width (440) that matches that of the first region (410) at boundaries between the first region (410) and the second region (420), and the width (440) of the second region (420) decreases to a minimum that is smaller than the width of the first region (410), such that a partially-corrugated sidewall along each side of the ridge waveguide is formed;
wherein the first region (410) comprises a wavelength-selective Bragg grating structure configured for a selected wavelength (430), and due to periodic nature of the first region (410), the wavelength-selective Bragg grating structure (430) is in a form of a sampled grating;
wherein the second region does not have the wavelength-selective Bragg grating structure; and
wherein the partially-corrugated sidewall increases waveguide losses for radiation in higher order lateral modes as compared to the fundamental waveguide mode.

14. A semiconductor laser distributed feedback, DFB, comprising:
a ridge or buried waveguide having alternating first and second regions (410, 420);
wherein the first region (410) has a constant width, and the second region (420) has a width (440) that matches that of the first region (410) at boundaries between the first region (410) and the second region (420), and the width (440) of the second region (420) decreases to a minimum that is smaller than the width of the first region (410), such that a partially-corrugated sidewall or interface on each side of the waveguide is formed;
wherein the first region (410) comprises a wavelength-selective Bragg grating structure configured for a selected wavelength (430), and due to periodic nature of the first region (410), the wavelength-selective Bragg grating structure (430) is in a form of a sampled grating;
wherein the second region does not have the wavelength-selective Bragg grating structure; and
wherein the partially-corrugated sidewall or interface increases waveguide losses for radiation in high order lateral modes as compared to the fundamental waveguide mode.

15. The laser of claim 1 or 7, wherein the width of the second region further decreases at least once to a minimum that is smaller than the width of the first region.

## Patentansprüche

1. DFB-Interbandkaskadenlaser (Interbandkaskadenlaser mit verteilter Rückkopplung), der Folgendes aufweist:
einen Rippenwellenleiter (400), der abwechselnd erste und zweite Bereiche (410, 420) aufweist;
wobei der erste Bereich (410) eine konstante Breite aufweist und der zweite Bereich (420) eine Breite (440) aufweist, die der des ersten Bereichs (410) an Grenzen zwischen dem ersten Bereich (410) und dem zweiten Bereich (420) entspricht und wobei die Breite (440) des zweiten Bereichs (420) derart mindestens einmal zu einem Maximum zunimmt, das größer als die Breite des ersten Bereichs (410) ist, dass eine teilgewellte Seitenwand entlang jeder Seite des Rippenwellenleiters gebildet wird;
wobei der erste Bereich (410) eine wellenlängenselektive Bragg-Gitterstruktur aufweist, die für eine ausgewählte Wellenlänge (430) konfiguriert ist, und aufgrund der periodischen Natur des ersten Bereichs (410) hat die wellenlängenselektive Bragg-Gitterstruktur (430) die Form eines Abtastgitters;
wobei der zweite Bereich keine wellenlängenselektive Bragg-Gitterstruktur aufweist; und
wobei die teilgewellte Seitenwand Wellenleiterverluste für Strahlung auf höheren oder lateralen Moden im Vergleich zur Grundwellenleitermode erhöht.

2. Laser nach Anspruch 1, wobei eine Abtastperiode der Gitterstruktur weniger als 10 µm beträgt.

3. Laser nach Anspruch 1, wobei jede Abschnittslänge des zweiten Bereichs gleich der Hälfte einer Abtastperiode der Gitterstruktur ist.

4. Laser nach Anspruch 1, wobei die Wellenlängenbreite des ersten Bereichs 4 µm bis 5 µm beträgt und die Wellenperiode innerhalb des teilgewellten Seitenwandabschnitts 2 µm bis 5 µm beträgt.

5. Laser nach Anspruch 1, wobei das Gitter eine Phasenverschiebung entlang des Wellenleiters aufweist, sodass der Laser ein phasenverschobener DFB-Laser, Laser mit verteilter Rückkopplung, ist.

6. Laser nach Anspruch 5, wobei der Laser ein um eine viertel Wellenlänge phasenverschobener DFB-Laser ist.

7. DFB-Halbleiterlaser (Halbleiterlaser mit verteilter Rückkopplung), der Folgendes aufweist:
einen Rippen- oder vergrabenen Wellenleiter (400), der abwechselnd erste und zweite Bereiche (410, 420) aufweist;
wobei der erste Bereich (410) eine konstante Breite aufweist und der zweite Bereich (420) eine Breite (440) aufweist, die der des ersten Bereichs (410) an Grenzen zwischen dem ersten Bereich (410) und dem zweiten Bereich (420) entspricht und wobei die Breite (440) des zweiten Bereichs (420) derart mindestens einmal zu einem Maximum zunimmt, das größer als die Breite des ersten Bereichs (410) ist, dass eine teilgewellte Seitenwand bzw. Schnittstelle an jeder Seite des Wellenleiters gebildet wird;
wobei der erste Bereich (410) eine wellenlängenselektive Bragg-Gitterstruktur aufweist, die für eine ausgewählte Wellenlänge (430) konfiguriert ist, und aufgrund der periodischen Natur des ersten Bereichs (410) hat die wellenlängenselektive Bragg-Gitterstruktur (430) die Form eines Abtastgitters;
wobei der zweite Bereich keine wellenlängenselektive Bragg-Gitterstruktur aufweist; und
wobei die teilgewellte Seitenwand bzw. Schnittstelle Wellenleiterverluste für Strahlung auf hohen oder lateralen Moden im Vergleich zur Grundwellenleitermode erhöht.

8. Laser nach Anspruch 1 oder 7, wobei eine Abtastperiode der Gitterstruktur derart ausgewählt wird, dass der Abstand zwischen resultierenden gleichmäßig beabstandeten Spitzen in einem Reflektivitätsspektrum größer als die volle Breite am halben Maximum eines Verstärkungsprofils des Lasers ist.

9. Laser nach Anspruch 1 oder 7, wobei eine Gitterteilung der Gitterstruktur derart ausgewählt ist, dass die Strahlung in der nullten Ordnung der Reflektivitätsspitze bevorzugt ist.

10. Laser nach Anspruch 7, wobei jede Abschnittslänge des zweiten Bereichs gleich der Hälfte einer Abtastperiode der Gitterstruktur ist.

11. Laser nach Anspruch 7, wobei das Gitter eine Phasenverschiebung entlang des Wellenleiters aufweist, sodass der Laser ein phasenverschobener DFB-Laser, Laser mit verteilter Rückkopplung, ist.

12. Laser nach Anspruch 11, wobei der Laser ein um eine viertel Wellenlänge phasenverschobener DFB-Laser ist.

13. DFB-Interbandkaskadenlaser (Interbandkaskadenlaser mit verteilter Rückkopplung), der Folgendes aufweist:
einen Rippenwellenleiter, der abwechselnd erste und zweite Bereiche (410, 420) aufweist;
wobei der erste Bereich (410) eine konstante Breite aufweist und der zweite Bereich (420) eine Breite (440) aufweist, die der des ersten Bereichs (410) an Grenzen zwischen dem ersten Bereich (410) und dem zweiten Bereich (420) entspricht und wobei die Breite (440) des zweiten Bereichs (420) derart auf ein Minimum abnimmt, das kleiner als die Breite des ersten Bereichs (410) ist, dass eine teilgewellte Seitenwand entlang jeder Seite des Rippenwellenleiters gebildet wird;
wobei der erste Bereich (410) eine wellenlängenselektive Bragg-Gitterstruktur aufweist, die für eine ausgewählte Wellenlänge (430) konfiguriert ist, und aufgrund der periodischen Natur des ersten Bereichs (410) hat die wellenlängenselektive Bragg-Gitterstruktur (430) die Form eines Abtastgitters;
wobei der zweite Bereich keine wellenlängenselektive Bragg-Gitterstruktur aufweist; und
wobei die teilgewellte Seitenwand Wellenleiterverluste für Strahlung auf höheren oder lateralen Moden im Vergleich zur Grundwellenleitermode erhöht.

14. DFB-Halbleiterlaser (Halbleiterlaser mit der Folgendes verteilter Rückkopplung), der Folgendes aufweist:
einen Rippen- oder vergrabenen Wellenleiter, der abwechselnd erste und zweite Bereiche (410, 420) aufweist;
wobei der erste Bereich (410) eine konstante Breite aufweist und der zweite Bereich (420) eine Breite (440) aufweist, die der des ersten Bereichs (410) an Grenzen zwischen dem ersten Bereich (410) und dem zweiten Bereich (420) entspricht und wobei die Breite (440) des zweiten Bereichs (420) derart auf ein Minimum abnimmt, das kleiner als die Breite des ersten Bereichs (410) ist, dass eine teilgewellte Seitenwand bzw. Schnittstelle an jeder Seite des Wellenleiters gebildet wird;
wobei der erste Bereich (410) eine wellenlängenselektive Bragg-Gitterstruktur aufweist, die für eine ausgewählte Wellenlänge (430) konfiguriert ist, und aufgrund der periodischen Natur des ersten Bereichs (410) hat die wellenlängenselektive Bragg-Gitterstruktur (430) die Form eines Abtastgitters;
wobei der zweite Bereich keine wellenlängenselektive Bragg-Gitterstruktur aufweist; und
wobei die teilgewellte Seitenwand bzw. Schnittstelle Wellenleiterverluste für Strahlung auf hohen oder lateralen Moden im Vergleich zur Grundwellenleitermode erhöht.

15. Laser nach Anspruch 1 oder 7, wobei die Breite des zweiten Bereichs ferner mindestens einmal auf ein Minimum abnimmt, das kleiner als die Breite des ersten Bereichs ist.

## Revendications

1. Laser, DFB, à rétroaction distribuée en cascade interbande comprenant :
un guide d'ondes à crête (400) comportant une première et une deuxième régions (410, 420) en alternance,
dans lequel la première région (410) a une largeur constante, et la deuxième région (420) a une largeur (440) qui correspond à celle de la première région (410) aux limites entre la première région (410) et la deuxième région (420), et la largeur (440) de la deuxième région (420) augmente au moins une fois jusqu'à un maximum qui est plus grand que la largeur de la première région (410), de telle sorte qu'une paroi latérale partiellement ondulée le long de chaque côté du guide d'ondes à crête soit formée,
dans lequel la première région (410) comprend une structure de réseau de Bragg sélective en longueur d'onde configurée pour une longueur d'onde sélectionnée (430) et en raison de la nature périodique de la première région (410), la structure de réseau de Bragg sélective en longueur d'onde (430) se présente sous la forme d'un réseau échantillonné ;
dans lequel la deuxième région n'a pas de structure de réseau de Bragg sélective en longueur d'onde ; et
dans lequel la paroi latérale partiellement ondulée augmente les pertes de guide d'ondes pour le rayonnement dans des modes latéraux d'ordre supérieur par rapport au mode de guide d'ondes fondamental.

2. Laser selon la revendication 1, dans lequel une période d'échantillonnage de la structure de réseau est inférieure à 10 µm.

3. Laser selon la revendication 1, dans lequel la longueur de section de chaque deuxième région est égale à la moitié d'une période d'échantillonnage de la structure de réseau.

4. Laser selon la revendication 1, dans lequel la largeur du guide d'onde de la première région est de 4 µm à 5 µm et la période d'ondulation à l'intérieur de la section de paroi latérale partiellement ondulée est de 2 µm à 5 µm.

5. Laser selon la revendication 1, dans lequel le réseau comprend un déphasage le long du guide d'onde, de sorte que le laser soit un laser à rétroaction distribuée déphasé, DFB.

6. Laser selon la revendication 5, dans lequel le laser est un laser DFB déphasé d'un quart de longueur d'onde.

7. Laser à rétroaction distribuée à semi-conducteur, DFB, comprenant :
un guide d'ondes à crête ou enterré (400) comportant des première et deuxième régions alternées (410, 420);
dans lequel la première région (410) a une largeur constante, et la deuxième région (420) a une largeur (440) qui correspond à celle de la première région (410) aux limites entre la première région (410) et la deuxième région (420) et la largeur (440) de la deuxième région (420) augmente au moins une fois jusqu'à un maximum qui est plus grand que la largeur de la première région (410), de telle sorte qu'une paroi latérale ou une interface partiellement ondulée de chaque côté du guide d'ondes soit formée,
dans lequel la première région (410) comprend une structure de réseau de Bragg sélective en longueur d'onde configurée pour une longueur d'onde sélectionnée (430), et en raison de la nature périodique de la première région (410), la structure de réseau de Bragg sélective en longueur d'onde (430) se présente sous la forme d'un réseau échantillonné ;
dans lequel la deuxième région n'a pas de structure de réseau de Bragg sélective en longueur d'onde ; et
dans lequel la paroi latérale ou l'interface partiellement ondulée augmente les pertes de guide d'ondes pour le rayonnement dans des modes latéraux d'ordre élevé par rapport au mode de guide d'ondes fondamental.

8. Laser selon la revendication 1 ou 7, dans lequel une période d'échantillonnage de la structure de réseau est sélectionnée de telle sorte que l'espacement résultant des pics uniformément espacés dans un spectre de réflectivité est supérieur à la largeur totale à mi-hauteur d'un profil de gain du laser.

9. Laser selon la revendication 1 ou 7, dans lequel un pas de réseau de la structure de réseau est choisi de telle sorte qu'un rayonnement dans l'ordre zéro du pic de réflectivité soit préféré.

10. Laser selon la revendication 7, dans lequel la longueur de chaque section de deuxième région est égale à la moitié de la période d'échantillonnage de la structure de réseau.

11. Laser selon la revendication 7, dans lequel le réseau comprend un déphasage le long du guide d'onde, de sorte que le laser soit un laser, DFB, à rétroaction distribuée déphasé.

12. Laser selon la revendication 11, dans lequel le laser est un laser DFB déphasé d'un quart de longueur d'onde.

13. Laser à rétroaction distribuée en cascade interbande, DFB, comprenant :
un guide d'ondes à crête comportant des première et deuxième régions alternées (410, 420), dans lequel la première région (410) a une largeur constante, et la deuxième région (420) a une largeur (440) qui correspond à celle de la première région (410) aux limites entre la première région (410) et la deuxième région (420) et la largeur (440) de la deuxième région (420) diminue jusqu'à un minimum qui est plus petit que la largeur de la première région (410), de telle sorte qu'une paroi latérale partiellement ondulée le long de chaque côté du guide d'ondes à crête soit formée,
dans lequel la première région (410) comprend une structure de réseau de Bragg sélective en longueur d'onde configurée pour une longueur d'onde sélectionnée (430), et en raison de la nature périodique de la première région (410), la structure de réseau de Bragg sélective en longueur d'onde (430) se présente sous la forme d'un réseau échantillonné ;
dans lequel la deuxième région n'a pas de structure de réseau de Bragg sélective en longueur d'onde ; et dans lequel la paroi latérale partiellement ondulée augmente les pertes de guide d'ondes pour le rayonnement dans des modes latéraux d'ordre supérieur par rapport au mode de guide d'ondes fondamental.

14. Laser à semi-conducteur à rétroaction distribuée, DFB, comprenant :
un guide d'ondes à crête ou enterré comportant une première et une deuxième régions alternées (410, 420) ;
dans lequel la première région (410) a une largeur constante, et la deuxième région (420) a une largeur (440) qui correspond à celle de la première région (410) aux limites entre la première région (410) et la deuxième région (420), et la largeur (440) de la deuxième région (420) diminue jusqu'à un minimum qui est inférieur à la largeur de la première région (410), de telle sorte qu'une paroi latérale ou une interface partiellement ondulée de chaque côté du guide d'ondes soit formée ;
dans lequel la première région (410) comprend une structure de réseau de Bragg sélective en longueur d'onde configurée pour une longueur d'onde sélectionnée (430), et en raison de la nature périodique de la première région (410), la structure de réseau de Bragg sélective en longueur d'onde (430) se présente sous la forme d'un réseau échantillonné ;
dans lequel la deuxième région n'a pas de structure de réseau de Bragg sélective en longueur d'onde, et la paroi latérale ou l'interface partiellement ondulée augmentent les pertes de guide d'onde pour le rayonnement dans des modes latéraux d'ordre élevé par rapport au mode de guide d'onde fondamental.

15. Laser selon la revendication 1 ou 7, dans lequel la largeur de la deuxième région diminue en outre au moins une fois jusqu'à un minimum qui est inférieur à la largeur de la première région.
